Europäisches Patentamt

European Patent Office

Office européen des brevets

(19)

(11) Veröffentlichungsnummer : **0 014 351**
**B1**

(12) **EUROPÄISCHE PATENTSCHRIFT**

(45) Veröffentlichungstag der Patentschrift :
01.09.82

(21) Anmeldenummer : 80100224.7

(22) Anmeldetag : 17.01.80

(51) Int. Cl.³ : **H 03 K 19/086**, H 03 K 19/092,
H 03 K 17/60, H 03 K 17/30

(54) **Monolithisch integrierbares NAND-Glied.**

(30) Priorität : 31.01.79 DE 2903659

(43) Veröffentlichungstag der Anmeldung :
20.08.80 (Patentblatt 80/17)

(45) Bekanntmachung des Hinweises auf die Patenterteilung : 01.09.82 Patentblatt 82/35

(84) Benannte Vertragsstaaten :
FR GB IT

(56) Entgegenhaltungen :
US A 3 700 915
US A 4 088 905
PROCEEDINGS OF THE INSTITUTION OF
ELECTRICAL ENGINEERS., Band 120, Nr. 2,
Februar 1973, Stevenage, Herts, GB,
A.C. PEATFIELD et al. : « Microwave data link for
computer communication », Seiten 186-190

(73) Patentinhaber : **SIEMENS AKTIENGESELLSCHAFT**
**Berlin und München**
**Postfach 22 02 61**
**D-8000 München 22 (DE)**

(72) Erfinder : **Güntner, Helmut**
**Feldstrasse 11b**
**D-8032 Gräfelfing (DE)**
Erfinder : **Wittenzellner, Ernst, Dipl.-Ing.**
**Behringstrasse 75b**
**D-8000 München 50 (DE)**

Imprimerie Jouve, 18, rue St-Denis, 75001 Paris, France

## Monolithisch integrierbares NAND-Glied

Die Erfindung betrifft eine monolithisch integrierbares NAND-Glied mit einer den Signalausgang bildenden Darlingtonstufe.

Ein NAND-Glied dieser Art ist zum Beispiel in « Siemens Datenbuch » 1976/77, Digitale Schaltungen, Seiten 420 bis 424 beschrieben. Hier dienen aus Dioden bestehende logische Gatter als Eingangsstufen.

Solche Schaltungen sind für viele Zwecke gut geeignet. Nun tritt in der Praxis bei der Entwicklung monolithisch integrierter Halbleiterschaltungen oft die Aufgabe auf, auf verschiedener technischer Grundlage beruhende Logikfamilien, zum Beispiel Schaltungen der TTL-Serie und der LSL-Serie, der DTL-Serie, der C-MOS-Serie und so weiter, zu vereinigen. Nachdem bekanntlich in allen gebräuchlichen Logikfamilien integrierte Stromtreiber mit hoher Ausgangsspannungsfestigkeit (zum Beispiel 30 V), zum Beispiel als Relais-Treiber in Schaltanlagen benötigt werden, wäre erwünscht, auch in dieser Beziehung eine gewisse Vereinheitlichung zu erzielen, um zu unterschiedlichen Logikfamilien gehörende Schaltungsteile leichter miteinander auch monolithisch zusammenfassen zu können.

Leider haben jedoch die verschiedenen gebräuchlichen Logikfamilien unterschiedliche Eingangs- und Ausgangspegeldefinitionen, je nach Versorgungsspannungsbereich (zum Beispiel Eingangsschwelle 1,5 V bei TTL, 6 V bei LSL). Um dem zu begegnen, hat man deshalb für die Gruppe der Logikserien mit 5 V Betriebsspannung und für die Gruppe der Logikschaltungen mit 12 bis 30 V Betriebsspannung verschiedene Stromtreibertypen mit den jeweils passenden Eingangsschwellspannungen benützt.

Die Erfindung hat nun die Aufgabe, eine monolithisch ohne Schwierigkeiten integrierbares NAND-Glied anzugeben, dessen Eingangsschwellspannung je nach angelegter Versorgungsspannung zwischen den beiden gebräuchlichen Werten von ca. 1,5 V und ca. 6 V umschaltet, so daß das NAND-Glied als Stromtreiber für alle gebräuchlichen Logikfamilien mit Versorgungsspannungen von ca. 3 V bis über 30 V geeignet ist.

Zur Lösung dieser Aufgabe wird das eingangs definierte NAND-Glied erfindungsgemäß derart ausgestaltet, daß der Eingang der Darlingtonstufe auf den nicht invertierten Ausgang eines Differenzverstärkers geschaltet ist, daß bei diesem Differenzverstärker mindestens zwei mit ihren Steuerelektroden je einen Signaleingang der Schaltung bildende und einander gleiche Eingangstransistoren mit jeweils derselben ihrer beiden stromführenden Elektroden mit derselben stromführenden Elektrode eines den Eingangstransistoren gleichen gemeinsamen Referenztransistors verbunden und dort von einer Stromquelle beaufschlagt sind, und daß außerdem die Steuerelektrode des Referenztransistors durch eine von Transistoren und Dioden gebildete Umschaltanlage gesteuert ist, derart, daß die Eingangstransistoren aufgrund der angelegten Versorgungsspannung entweder auf einen ersten Schwellspannungswert oder auf einen zweiten Schwellspannungswert eingestellt sind.

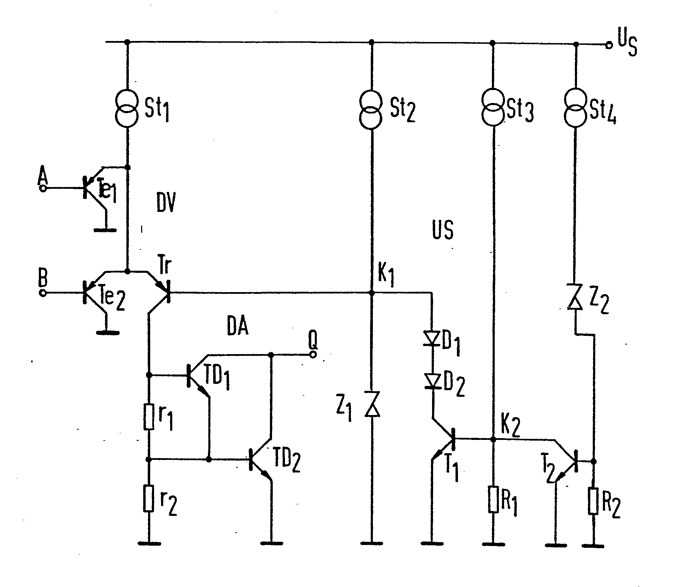

Aufgrund der soeben gegebenen Definition bildet die erfindungsgemäße Schaltung ein Positiv-NAND-Glied mit offenem Kollektor am Ausgang und z.B. zwei Eingängen. Sie eignet sich z.B. zum Treiben von Relais an 30 V Versorgungsspannung, vor allem dann, wenn die aus der Figur ersichtliche Schaltungsweise in Bipolartechnik angewendet wird. Die Eingangsschwelle ist z.B. auf TTL oder auf LSL-Pegel einstellbar.

Es wird nun die aus der Figur ersichtliche bevorzugte Schaltungsweise einer Vorrichtung gemäß der Erfindung näher beschrieben.

In dem gezeichneten Ausführungsbeispiel sind zwei Eingangstransistoren $Te_1$ und $Te_2$ vorgesehen, die beide vom pnp-Typ sind. Dasselbe gilt für den Referenztransistor $Tr$. Entsprechend der oben gegebenen Definition sind die Emitterelektroden dieser drei Transistoren $Te_1$, $Te_2$ und $Tr$ gemeinsam an den zugehörigen Anschluß eines ersten Stromversorgers $St_1$ gelegt. Die Kollektoren der beiden Eingangstransistoren $Te_1$ und $Te_2$ liegen am gemeinsamen Bezugspotential der Schaltung, also an Masse, während der Kollektor des Referenztransistors $Tr$ zur Steuerung der den Ausgang $Q$ der Logik bildenden Darlingtonschaltung dient.

Hierzu sind im Beispielsfalle zwei npn-Transistoren $TD_1$ und $TD_2$ vorgesehen, die mit den beiden Widerständen $r_1$ und $r_2$ in der aus der Figur ersichtlichen Weise zusammengeschaltet sind. Dabei ist die Basis des Transistors $TD_1$ unmittelbar mit dem Kollektor des Referenztransistors $Tr$ verbunden, während zwischen der Basis des Transistors $TD_1$ und der Basis des zweiten Transistors $TD_2$ der Darlingtonstufe der über den Widerstand $r_1$ gegebene Spannungsabfall vorgesehen ist. Die Kollektoren der beiden Transistoren $TD_1$ und $TD_2$ bilden den Signalausgang der Logikschaltung $Q$. Der Emitter des ersten Transistors $TD_1$ liegt zusammen mit der Basis des zweiten Transistors $TD_2$ an dem durch die Serienschaltung des bereits genannten Widerstands $r_1$ und einem am Bezugspotential (Masse) liegenden zweiten Widerstand $r_2$ definierten Spannungsteilerpunkt zwischen diesen beiden Widerständen. Der Emitter des zweiten Transistors $TD_2$ der Darlingtonstufe liegt ebenfalls am Bezugspotential.

Die Umschaltanlage $US$ enthält drei Stromversorger $St_2$, $St_3$ und $St_4$, zwei Zenerdioden $Z_1$ und $Z_2$, zwei weitere Dioden $D_1$ und $D_2$, zwei npn-Transistoren $T_1$ und $T_2$ sowie zwei ohmsche Widerstände in folgender Schaltweise :

Der erste der genannten Stromversorger $St_2$ ist mit der Anode einer in Sperrichtung gepolten Zenerdiode $Z_1$ verbunden, deren Anode am gemeinsamen Bezugspotential der Anlage, also an Masse liegt. Außerdem liegt die Kathode der Zenerdiode $Z_1$ an der Basis des Referenztransistors Tr des Differenzverstärkers. Durch diese Anschaltung ist ein Schaltungsknoten $K_1$ zwischen den Schaltungsteilen Tr, $Z_1$ und $St_2$ gegeben, der über die beiden hintereinandergeschalteten und von $K_1$ aus gesehen in Flußrichtung liegenden Dioden $D_1$ und $D_2$ an den Kollektor des npn-Transistors $T_1$ geschaltet ist, dessen Emitter am gemeinsamen Bezugspotential (Masse) und dessen Basis an einem weiteren Schaltungsknoten $K_2$ liegt.

Dieser zweite Schaltungsknoten $K_2$ ist außerdem über einen Widerstand $R_1$ an das gemeinsame Bezugspotential sowie unmittelbar an den Kollektor des npn-Transistors $T_2$ gelegt und erhält außerdem seinen Strom durch direkte Verbindung mit dem Stromversorger $St_3$. Auch der Emitter dieses Transistors $T_2$ liegt unmittelbar an Masse, während seine Basis über die in Sperrichtung liegende zweite Zenerdiode $Z_2$ von dem zuletzt genannten Stromversorger $St_4$ beaufschlagt und außerdem über den Ableitewiderstand $R_2$ an Masse gelegt ist.

Die Stromversorger $St_1$ bis $St_4$ bestehen im Beispielsfalle zweckmäßig aus je einem pnp-Transistor, dessen Emitter an das andere (in diesem Falle positive) Versorgungspotential $U_s$ gelegt ist, während der Kollektor des jeweiligen Transistors die Verbindung zu dem jeweiligen zu beaufschlagenden herstellt. Die Basisanschlüsse der Stromversorgungstransistoren liegen an einem — vorzugsweise gemeinsamen — Stromsteuerungspotential. Die einzelnen Betriebspotentiale sind auf das gemeinsame Bezugspotential. Die einzelnen Betriebspotentiale sind auf das gemeinsame Bezugspotential (Masse) bezogen.

Die Schaltschwelle an den Eingängen A und B beträgt ca. 6,8 V bei einer Speisespannung $U_s$ > ca. 8 V. Sinkt die Speisespannung $U_s$ unter den genannten Wert, das heißt 8 V ab, so sperrt die Zenerdiode $Z_2$, und die Referenzspannung $U_r$ für die Schwelle an den Eingängen A und B wird auf ca. 1,5 V umgeschaltet.

Wenn nämlich $U_s$ merklich kleiner als 8 V ist und damit die Zenerdiode $Z_2$ gesperrt ist, ist auch der Transistor $T_2$ gesperrt und der Transistor $T_1$ leitend. Damit liegt als Referenzspannung am Differenzeingangsverstärker DV eine Spannung von etwa 1,5 V, also die Summe der beiden Diodenspannungen $D_1$ und $D_2$, wodurch die Eingangsschwelle an A beziehungsweise B mit ca. 1,5 V festgelegt ist.

Liegt hingegen die Versorgungsspannung $U_s$ über 8 V, so wird die Zenerdiode $Z_2$ und der Transistor $T_2$ leitend, während der Transistor $T_1$ auf Grund der angegebenen Schaltung sperrt. Als Referenzspannung liegt nunmehr die Spannung der Zenerdiode $Z_1$ an, so daß die Eingangsschwelle an den Eingängen A und B etwa 6 bis 7 V beträgt. ·

Die beschriebene Schaltung läßt sich ohne weiteres abwandeln, ohne daß die angestrebte Wirkung verlorengeht. So kann man durch Umkehr der Transistortypen in dem eben beschriebenen Ausführungsbeispiel in den jeweils entgegengesetzten Typ eine ähnliche Wirkung erhalten. Im Ausführungsbeispiel wurden, was schon bei monolithischer Integration der Anlage praktisch notwendig ist, einander gleiche Zenerdioden $Z_1$ und $Z_2$ verwendet. Man kann allerdings bei Bedarf unterschiedliche Zenerdioden verwenden, wenn man den hierzu erforderlichen technischen Aufwand nicht scheut. Auch eine Ausgestaltung der Anordnung unter Verwendung von CMOS-Transistoren ist möglich. An den Knoten $K_1$ können weitere Stufen DV angeschlossen werden (zum Beispiel 4fach-NAND-GLied in einem Gehäuse).

Im Betrieb werden die Eingänge A, B und so weiter durch die Signalausgänge von logischen Schaltungen gesteuert, ebenso wie der Ausgang Q zur Beaufschlagung weiterer Schaltungsteile vorgesehen sein kann.

## Ansprüche

1. Monolithisch integrierbares NAND-GLied mit einer den Signalausgang bildenden Darlingtonstuge, dadurch gekennzeichnet, daß der Eingang der Darlingtonstufe auf den nicht invertierten Ausgang eines Differenzverstärkers (DV) geschaltet ist, daß bei diesem Differenzverstärker (DV) mindestens zwei mit ihren Steuerelektroden je einen Signaleingang (A, B,..) der Schaltung bildende und einander gleiche Eingangstransistoren ($Te_1$, $Te_2$,..) mit jeweils derselben ihrer beiden stromführenden Elektroden mit derselben stromführenden Elektrode eines den Eingangstransistoren gleichen gemeinsamen Referenztransistors (Tr) verbunden und dort von einer Stromquelle ($St_1$) beaufschlagt sind, und daß außerdem die Steuerelektrode des Referenztransistors (Tr) durch eine von Transistoren ($T_1$, $T_2$) und Dioden ($Z_1$, $Z_2$ ; $D_1$, $D_2$) gebildete Umschaltanlage gesteuert ist, derart, daß die Eingangstransistoren ($Te_1$, $Te_2$,...) aufgrund der angelegten Versorgungsspannung entweder auf einen ersten Schwellspannungswert oder auf einen zweiten Schwellspannungswert eingestellt sind.

2. NAND-Glied nach Anspruch 1, dadurch gekennzeichnet, daß als Transistoren Bipolartransistoren verwendet sind, daß dabei die Eingangstransistoren ($Te_1$, $Te_2$,..) sowie der Referenztransistor (Tr) und die als Stromquelle vorgesehenen Transistoren vom einen Transistortyp sind, während die übrigen in der Schaltung verwendeten Transistoren ($TD_1$, $TD_2$, $T_1$, $T_2$) vom hierzu komplementären Transistortyp sind.

3. NAND-Glied nach Anspruch 2, dadurch gekennzeichnet, daß der Differenzverstärker (DV) von pnp-Transistoren ($Te_1$, $Te_2$,...Tr) gebildet ist.

4. NAND-Glied nach den Ansprüchen 1 bis 3, dadurch gekennzeichnet, daß im Differenzverstärker (DV) die an dessen Aufbau beteiligten Transistoren ($Te_1$, $Te_2$,...Tr) über ihre Emitteranschlüsse miteinander verbunden sind.

5. NAND-Glied nach den Ansprüchen 2 bis 4, dadurch gekennzeichnet, daß in der Umschaltanlage (US) ein erster Stromversorger (ST₂) an einen Schaltungsknoten (K₁) gelegt und dieser Schaltungsknoten sowohl mit der Basis des Referenztransistors (Tr) des Differenzverstärkers (DV) als auch über eine in Sperrichtung gepolte erste Zenerdiode (Z₁) mit dem Bezugspotential als auch über wenigstens eine in Flußrichtung liegende Diode (D₁, D₂) mit dem Kollektor eines ersten Transistors (T₁) verbunden ist, daß ferner der Emitter dieses ersten Transistors am Bezugspotential und seine Basis an einem zweiten Schaltungsknoten (K₂) liegt, daß außerdem dieser zweite Schaltungsknoten (K₂) über einen Ableitewiderstand (R₁) auf das Bezugspotential und unmittelbar an einen weiteren Stromversorger (St₃) und unmittelbar an den Kollektor eines zweiten Transistors (T₂) geschaltet ist, dessen Emitter am Bezugspotential und dessen Basis an dem Spannungsteilerpunkt einer aus einem am Bezugspotential liegenden Ableitewiderstand (R₂) und einer in Sperrichtung gepolten und mit ihrer Anode an einem weiteren Stromversorger liegenden zweiten Zenerdiode (Z₂) bestehenden Reihenschaltung angelegt ist.

6. NAND-Glied nach den Ansprüchen 1 bis 5, dadurch gekennzeichnet, daß die Stromversorger (St₁,...St₄) durch je einen Transistor vom Typ der den Differenzverstärker (DV) bildenden Transistoren (Te₁, Te₂,...Tr) gebildet sind, deren Emitter mit einem Versorgungspotential ( + Uₛ), deren Basis an einem — insbesondere gemeinsamen — Steuerpotential und deren Kollektoren an dem jeweils mit Strom zu versorgenden Schaltungspunkt (DV, K₁, K₂, Z₂) der Schaltung liegt.

7. NAND-Glied nach den Ansprüchen 1 bis 6, dadurch gekennzeichnet, daß die Darlingtonstufe (DA) aus zwei Transistoren (TD₁, TD₂) und zwei Widerständen (r₁, r₂) besteht, daß dabei die Basis des ersten Transistors (TD₁) und die Reihenschaltung der beiden Widerstände mit dem Kollektor des Referenztransistors (Tr) des Differenzverstärkers (DV) verbunden und der andere Endpunkt der Widerstands-Reihenschaltung (r₁, r₂) am Bezugspotential liegt, daß ferner sowohl der Emitter des ersten Transistors (TD₁) als auch die Basis des zweiten Transistors (TD₂) am Spannungsteilerpunkt der Widerstands-Reihenschaltung (r₁, r₂) liegen und daß schließlich der Emitter des zweiten Transistors (TD₂) der Darlingtonstufe am Bezugspotential liegen und der Ausgang der Schaltung (Q) durch die miteinander verbundenen Kollektoren der Darlingtonstufe gegeben ist.

## Claims

1. A monolithically integratable NAND-element comprising a Darlington stage which forms the signal output, characterised in that the input of the Darlington stage is connected to the noninverting output of a differential amplifier (DV) having at least two input transistors (Te₁, Te₂..) which are mutually similar and provide respective signal inputs (A, B..) via their individual control electrodes, and each has a like one of their two current-carrying electrodes connected to a common like current-carrying electrode of a common reference transistor (Tr) which is identical to the input transistors, and which is fed from a current source (St₁), and that furthermore the control electrode of the reference transistor (Tr) is controlled by a change-over system formed by transistors (T₁, T₂) and diodes (Z₁, Z₂ ; D₁, D₂), in such manner that in dependence upon the strength of the applied supply voltage the input transistors (Te₁, Te₂,...) are adjusted either to a first threshold voltage value or to a second threshold voltage value.

2. A NAND-element as claimed in claim 1, characterised in that said transistors are bipolar transistors, said input transistors (Te₁, Te₂,...), said reference transistor (Tr) and transistors which are provided as a current source are of one transistor type, whereas the remaining transistors (TD₁, TD₂, T₁, T₂) which are used in the circuit are of the transistor type complementary thereto.

3. A NAND-element as claimed in claim 2, characterised in that the differential amplifier (DV) is formed by pnp-transistors (Te₁, Te₂,...Tr).

4. A NAND-element as claimed in claims 1 to 3, characterised in that said differential amplifier (DV) has its transistors (Te₁, Te₂...Tr) connected to one another by their emitter terminals.

5. A NAND-element as claimed in claims 2 to 4, characterised in that said change-over system (US) has a first current supply unit (St₂) connected to a circuit node (K₁), and this circuit node is connected to the base electrode of the reference transistor (Tr) of the differential amplifier (DV), and to the reference potential by means of a first Zener diode (Z₁) poled in the blocking direction, and which node is connected to the collector of a first transistor (T₁) by means of at least one forward-poled diode (D₁, D₂), the emitter of this first transistor being connected to the reference potential and its base electrode being connected to a second circuit node (K₂), which second circuit node (K₂) is connected via a leakage resistor (R₁) to the reference potential, and directly to a further current supply circuit (St₃) and directly to the collector of a second transistor (T₂), whose emitter is connected to the reference potential and whose base electrode is connected to the voltage divider point of a series connection which consists of a leakage resistor (R₂) and a second Zener diode (Z₂) poled in the blocking direction, with its anode connected to a further current supply unit.

6. A NAND-element as claimed in claims 1 to 5, characterised in that the current supply units (St₁,...St₄) are each formed by a respective transistor of the same type as the transistors (Te₁, Te₂,...Tr) which form the differential amplifier (DV) and whose emitter electrodes are connected to a — in particular common — control potential ( + Uₛ), and whose collector electrodes are respectively connected to the switching point (DV,

$K_1$, $K_2$, $Z_2$) of the circuit which is respectively to be supplied with current.

7. A NAND-element as claimed in claims 1 to 6, characterised in that the Darlington stage (DA) consists of two transistors ($TD_1$, $TD_2$) and two resistors ($r_1$, $r_2$), and that the base electrode of the first transistor ($TD_1$) and the series connection of the two resistors are connected to the collector electrode of the reference transistor (Tr) of the differential amplifier (DV), and the other end point of the resistor series connection ($r_1$, $r_2$) is connected to the reference potential, and that furthermore both the emitter electrode of the first transistor ($TD_1$) and the base electrode of the second transistor ($TD_2$) are connected to the voltage divider point of the resistor series connection ($r_1$, $r_2$), and that finally the emitter electrode of the second transistor ($TD_2$) of the Darlington stage is connected to the reference potential and the output of the circuit (Q) is fed via the collectors of the Darlington stage, which are connected together.

## Revendications

1. Circuit NON ET intégré monolithique avec un circuit de Darlington constituant la sortie des signaux, caractérisé par le fait que l'entrée du circuit de Darlington est reliée à la sortie non inverseuse d'un amplificateur différentiel (DV), que dans cet amplificateur différentiel (DV) au moins deux transistors d'entrée ($Te_1$, $Te_2$...) identiques entre eux et formant chacun par leurs électrodes de commande une entrée des signaux (A, B), sont respectivement reliés par la même de leurs deux électrodes parcourues par le courant, à la même électrode, parcourue par le courant, d'un transistor de référence commun (Tr) et identique aux deux transistors d'entrée, et y sont alimentés par une source de courant d'attaque ($St_1$), et qu'en outre l'électrode de commande du transistor de référence (Tr) est contrôlée de telle manière par un dispositif de commutation formé par l'un des transistors ($T_1$, $T_2$) et par des diodes ($Z_1$, $Z_2$ ; $D_1$, $D_2$), que les transistors d'entrée ($Te_1$, $Te_2$...) sont réglés, en raison de la tension de polarisation appliquée, soit à une première valeur de seuil de la tension, soit à une seconde valeur de seuil de la tension.

2. Circuit NON ET selon la revendication 1, caractérisé par le fait que l'on utilise comme transistor des transistors bipolaires, que les transistors d'entrée ($Te_1$, $Te_2$...) de même que le transistor de référence (Tr) et les transistors prévus comme source de courant d'attaque sont d'un premier type de transistor alors que les autres transistors utilisés dans le montage ($TD_1$, $TD_2$, $T_1$, $T_2$) sont des transistors d'un type complémentaire aux précédents.

3. Circuit NON ET selon la revendication 2, caractérisé par le fait que l'amplificateur différentiel (DV) est formé par des transistors pnp ($Te_1$, $Te_2$...Tr).

4. Circuit NON ET selon les revendications 1 à 3, caractérisé par le fait que dans l'amplificateur différentiel (DV), les transistors ($Te_1$, $Te_2$...Tr) participant à sa constitution, sont reliés entre eux par leurs bornes d'émetteurs.

5. Circuit NON ET selon les revendications 2 à 4, caractérisé par le fait que dans le dispositif de commutation (US), une première source de courant d'attaque ($St_2$) est reliée à un point ($K_1$) du montage, point de circuit qui est relié aussi bien à la base du transistor de référence (Tr) de l'amplificateur différentiel (DV), qu'à un potentiel de référence, par l'intermédiaire d'une première diode de Zener montée en direction inverse et au collecteur d'un premier transistor ($T_1$), par l'intermédiaire d'au moins une diode ($D_1$, $D_2$) située dans la direction du courant, qu'en outre l'émetteur de ce premier transistor est relié au potentiel de référence et sa base est reliée à un second point ($K_2$) du montage, qu'en plus, ce second point ($K_2$) du montage est relié au potentiel de référence, par l'intermédiaire d'une résistance de fuite ($R_1$), et directement à une seconde source de courant d'attaque ($St_3$) et directement à la base d'un second transistor ($T_2$) dont l'émetteur est au potentiel de référence et dont le collecteur est relié au point de prélèvement d'un diviseur de tension constitué par un montage série d'une résistance de charge ($R_2$) reliée au potentiel de référence et d'une seconde diode de Zener ($Z_2$) montée dans la direction inverse et dont l'anode est reliée à une source supplémentaire de courant d'attaque.

6. Circuit NON ET selon les revendications 1 à 5, caractérisé par le fait que les sources de courant d'attaque ($St_1$...$St_4$) sont respectivement constituées par un transistor du type des transistors ($Te_1$, $Te_2$...Tr) formant l'amplificateur différentiel (DV), et dont les émetteurs sont à un potentiel d'alimentation ( + $U_S$), dont les bases sont au potentiel de commande, en particulier commun, et dont les collecteurs sont reliés aux points respectifs (DV, $K_1$, $K_2$ ; $Z_2$) du montage à alimenter en courant.

7. Circuit NON ET selon les revendications 1 à 6, caractérisé par le fait que le circuit Darlington (DA) est constitué par deux transistors ($TD_1$, $TD_2$) et par deux résistances ($r_1$, $r_2$), que la base du premier transistor ($TD_1$) et le montage série des deux résistances est relié au collecteur du transistor de référence (Tr) de l'amplificateur différentiel (DV) et l'autre extrémité du montage série des résistances ($r_1$, $r_2$) est reliée au potentiel de référence, qu'en outre l'émetteur du premier transistor ($TD_1$) et la base du second transistor ($TD_2$) sont reliés au point de prise du diviseur de tension du montage série des résistances ($r_1$, $r_2$), et qu'enfin l'émetteur du second transistor ($TD_2$) du circuit Darlington est au potentiel de référence, alors que la sortie du montage (Q) est formée par les collecteurs, reliés entre eux, du circuit Darlington.